# EUROPÄISCHE PATENTSCHRIFT

(11) **EP 2 558 233 B1**
(45) Veröffentlichungstag und Bekanntmachung des Hinweises auf die Patenterteilung: **02.01.2019**
(21) Anmeldenummer: 11714744.7
(22) Anmeldetag: 11.04.2011
(51) Int. Cl.: B22D 27/04, C01B 33/02, C30B 15/00, C30B 29/02

(54) **HERSTELLUNG EINES KRISTALLINEN HALBLEITERWERKSTOFFS**
PRODUCTION OF A CRYSTALLINE SEMICONDUCTOR MATERIAL
FABRICATION D'UN MATÉRIAU SEMI-CONDUCTEUR CRISTALLIN

(30) Priorität: 13.04.2010 DE 102010015354
(43) Veröffentlichungstag der Anmeldung: 20.02.2013
(73) Patentinhaber: Schmid Silicon Technology GmbH, 72250 Freudenstadt (DE)
(72) Erfinder: KERAT, Uwe, 72270 Baiersbronn (DE); SCHMID, Christian, 72250 Freudenstadt (DE); HAHN, Jochem, 72108 Rottenburg a. N. (DE)
(74) Vertreter: Patentanwaltskanzlei Cartagena
(86) Internationale Anmeldenummer: PCT/EP2011/055636
(87) Internationale Veröffentlichungsnummer: WO 2011/128296

(56) Entgegenhaltungen:
- EP-A1- 2 544 999
- DE-A1- 2 952 603
- US-A- 4 102 767
- US-A- 4 377 564
- US-A- 5 510 095

## Beschreibung

Beschrieben wird ein Verfahren zur Herstellung eines kristallinen Halbleiterwerkstoffs, der sich insbesondere zur Verwendung in der Photovoltaik und in der Mikroelektronik eignet.

Elementares Silizium findet in unterschiedlichen Reinheitsgraden u.a. in der Photovoltaik (Solarzellen) und in der Mikroelektronik (Halbleiter, Computerchips) Verwendung. Demgemäß ist es üblich, elementares Silizium anhand seines Reinheitsgrades zu klassifizieren. Man unterscheidet beispielsweise "electronic grade silicium" mit einem Anteil an Verunreinigungen im ppt-Bereich und "solar grade silicium", das einen etwas höheren Anteil an Verunreinigungen aufweisen darf.

Bei der Herstellung von solar grade silicium und electronic grade silicium geht man stets von metallurgischem Silizium (in der Regel 98 - 99 % Reinheit) aus und reinigt dieses über ein mehrstufiges, aufwendiges Verfahren auf. So ist es beispielsweise möglich, das metallurgische Silizium in einem Wirbelschichtreaktor mit Chlorwasserstoff zu Trichlorsilan umzusetzen, das anschließend zu Siliziumtetrachlorid und Monosilan disproportioniert wird. Letzteres lässt sich thermisch in seine Bestandteile Silizium und Wasserstoff zersetzen. Ein entsprechender Verfahrensablauf ist beispielsweise in der WO 2009/121558 A2 beschrieben.

Das auf diesem Weg erhaltene Silizium weist in aller Regel mindestens eine ausreichend hohe Reinheit auf, um als solar grade silicium klassifiziert zu werden. Noch höhere Reinheiten lassen sich gegebenenfalls durch nachgeschaltete zusätzliche Aufreinigungsschritte erzielen. Zu erwähnen sind in diesem Zusammenhang insbesondere die Aufreinigung durch gerichtete Erstarrung (directional solidification) sowie das Zonenschmelzen. Darüber hinaus ist es für viele Anwendungen günstig oder sogar erforderlich, das in der Regel polykristallin erhaltene Silizium in monokristallines Silizium umzuwandeln. So weisen Solarzellen aus monokristallinem Silizium einen in der Regel deutlich höheren Wirkungsgrad auf als Solarzellen aus polykristallinem Silizium. Die Umwandlung von polykristallinem Silizium in monokristallines erfolgt in der Regel durch Aufschmelzen des polykristallinen Siliziums und anschließendes Kristallisieren in monokristalliner Struktur mit Hilfe eines Impfkristalles. Gebräuchliche Verfahren zur Umwandlung von Polysilizium in monokristallines Silizium sind das Czochralski-Verfahren sowie das vertikale tiegelfreie Fließzonenverfahren (Float Zone-Verfahren) mit frei schwebender Schmelze (siehe z.B. DE 2952603 A1 oder US 5510095 A).

Aus der US 4102767 A ist ein Verfahren zur Herstellung von Silizium bekannt, bei dem eine Silizium-Vorläuferverbindung in einem Lichtbogen mit einem Reduktionsmittel umgesetzt wird. Entstehendes Silizium wird in einen sogenannten Reduktionsreaktor eingespeist. Aus diesem wird flüssiges Silizium in eine flache Gussform überführt, in der man es abkühlen lässt. In einer Heizzone kann bereits erstarrtes Silizium noch einmal aufgeschmolzen werden, beispielsweise mittels eines Lasers, zwecks Überführung in einen Einkristall.

Aus der US 4377564 A ist es bekannt, Silizium zum Zwecke der Beschichtung von Oberflächen in gasförmiger Form bereit zu stellen. Hierzu kann ein Silizium-Precursor in einem hocherhitzten Gasstrom zersetzt oder reduziert werden. Das dabei entstehende Silizium wird direkt aus der Gasphase auf einem Festkörper abgeschieden.

In der Summe gestaltet sich die Herstellung von hochreinem Silizium bzw. gegebenenfalls hochreinem monokristallinem Silizium energetisch sehr aufwendig, sie ist gekennzeichnet durch eine Abfolge von chemischen Prozessen und Aggregatzustandsänderungen. Verwiesen wird in diesem Zusammenhang beispielsweise auf die bereits erwähnte WO 2009/121558 A2. Das in dem beschriebenen mehrstufigen Prozeß gewonnene Silizium fällt in einem Pyrolysereaktor in Form von festen Stangen an, die zur anschließenden Weiterverarbeitung, beispielsweise in einem Czochralski-Verfahren, gegebenenfalls zerkleinert und wieder aufgeschmolzen werden müssen.

Die vorliegend beschriebene Erfindung baut auf den in der deutschen Patentanmeldung DE 10 2010 011 853 A1 sowie der als WO 2010/060630 A2 veröffentlichten internationalen Anmeldung sowie der EP 2 544 999 A1 beschriebenen Erfindungen auf, die jeweils ein Verfahren zum Gegenstand haben, bei dem Silizium in flüssiger Form erhalten wird. Weiterentwicklungen der Anmelderin führten zu dem Verfahren mit den Merkmalen des Anspruchs 1.

Bei dem erfindungsgemäßen Verfahren handelt es sich um ein Verfahren zur Herstellung eines kristallinen Halbleiterwerkstoffs, insbesondere von kristallinem Silizium. Das Verfahren umfasst mehrere Schritte, nämlich:
(1) Das Einspeisen von Partikeln aus dem Halbleiterwerkstoff oder alternativ das Einspeisen einer Vorläuferverbindung des Halbleiterwerkstoffs in einen Gasstrom, wobei der Gasstrom eine ausreichend hohe Temperatur aufweist, um die Partikel aus dem Halbleiterwerkstoff aus dem festen in den flüssigen und/oder gasförmigen Zustand zu überführen und/oder um die Vorläuferverbindung thermisch zu zersetzen. Gegebenenfalls können in den Gasstrom sowohl Partikel aus dem Halbleiterwerkstoff als auch eine Vorläuferverbindung des Halbleiterwerkstoffs eingespeist werden.
   Bei den Partikeln aus dem Halbleiterwerkstoff handelt es sich insbesondere um metallische Siliziumpartikel, wie sie z.B. beim Zersägen von Siliziumblöcken zu dünnen Waferscheiben aus Silizium in großen Mengen anfallen können. Unter Umständen können die Partikel oberflächlich zumindest leicht oxidiert sein, vorzugsweise bestehen sie jedoch aus metallischem Silizium.
   Bei der Vorläuferverbindung des Halbleiterwerkstoffs handelt es sich bevorzugt um eine Silizium-Wasserstoff-Verbindung, besonders bevorzugt um Monosilan (SiH₄). Allerdings ist beispielsweise auch die Zersetzung von Chlorsilanen wie z.B. insbesondere Trichlorsilan (SiHCl₃) denkbar.
   Der Gasstrom, in den die Partikel aus dem Halbleiterwerkstoff und/oder die Vorläuferverbindung des Halbleiterwerkstoffes eingespeist werden, umfasst in der Regel mindestens ein Trägergas, in bevorzugten Ausführungsformen besteht er aus einem solchen. Als Trägergas kommt insbesondere Wasserstoff in Frage, was insbesondere dann vorteilhaft ist, wenn es sich bei der Vorläuferfverbindung um eine Silizium-Wasserstoff-Verbindung handelt. In weiteren bevorzugten Ausführungsformen kann es sich bei dem Trägergas auch um eine Trägergasmischung aus Wasserstoff und einem Edelgas, insbesondere Argon, handeln. Das Edelgas ist in der Trägergasmischung bevorzugt in einem Anteil zwischen 1 % und 50 % enthalten.
   Bevorzugt weist der Gasstrom eine Temperatur zwischen 500 und 5.000 °C, bevorzugt zwischen 1000 und 5.000 °C, besonders bevorzugt zwischen 2.000 und 4.000 °C, auf. Bei einer solchen Temperatur können zum einen z.B. Partikel aus Silizium verflüssigt bzw. im Gasstrom sogar mindestens teilweise verdampft werden. Auch Silizium-Wasserstoff-Verbindungen werden bei solchen Temperaturen in der Regel ohne weiteres zersetzt.
   Besonders bevorzugt handelt es sich bei dem Gasstrom um ein Plasma, insbesondere um ein Wasserstoff-Plasma. Bei einem Plasma handelt es sich bekanntlich um ein teilweise ionisiertes Gas, das zu einem nennenswerten Anteil freie Ladungsträger wie Ionen oder Elektronen enthält. Erhalten wird ein Plasma stets durch äußere Energiezufuhr, welche insbesondere durch thermische Anregung, durch Strahlungsanregung oder durch Anregungen durch elektrostatische oder elektromagnetische Felder erfolgen kann. Vorliegend ist insbesondere die letztere Anregungsmethode bevorzugt. Entsprechende Plasmageneratoren sind kommerziell erhältlich und müssen im Rahmen der vorliegenden Anmeldung nicht näher erläutert werden.
(2) Nach dem Einspeisen von Partikeln aus dem Halbleiterwerkstoff und/oder der Vorläuferverbindung des Halbleiterwerkstoffes in den Gasstrom das Auskondensieren und/oder Abtrennen von flüssigem Halbleiterwerkstoff aus dem Gasstrom. Hierfür kommt in bevorzugten Ausführungsformen ein Reaktorbehälter zum Einsatz, in den der Gasstrom mit den Partikeln aus dem Halbleiterwerkstoff und/oder der Vorläuferverbindung des Halbleiterwerkstoffs bzw. mit entsprechenden Folgeprodukten eingeleitet wird. Ein solcher Reaktorbehälter dient zum Sammeln und gegebenenfalls zum Kondensieren des flüssigen und/oder gasförmigen Halbleiterwerkstoffs. Insbesondere ist er dazu vorgesehen, die im Rahmen eines erfindungsgemäßen Verfahrens entstehende Mischung aus Trägergas, Halbleiterwerkstoff (flüssig und/oder gasförmig) und gegebenenfalls gasförmigen Zerfallsprodukten aufzutrennen. Nach Einspeisen der Partikel aus dem Halbleiterwerkstoff und/oder der Vorläuferverbindung des Halbleiterwerkstoffs in den Gasstrom umfasst dieser ja nicht mehr nur ein entsprechendes Trägergas, sondern eben auch noch weitere Bestandteile.
   Der Reaktor umfasst in der Regel einen hitzebeständigen Innenraum. Damit der durch den hocherhitzten Gasstrom nicht zerstört wird, ist er in der Regel mit entsprechenden hochtemperaturbeständigen Materialien ausgekleidet. Geeignet sind beispielsweise Auskleidungen auf Basis von Graphit oder Si₃N₄. Dem Fachmann sind geeignete hochtemperaturbeständige Materialien bekannt.
   Innerhalb des Reaktors spielt insbesondere die Frage des Übergangs von gegebenenfalls gebildeten Dämpfen wie Siliziumdämpfen in die flüssige Phase eine große Rolle. Dafür ist natürlich die Temperatur der Reaktorinnenwände ein wichtiger Faktor, sie liegt daher in der Regel oberhalb des Schmelzpunkts und unterhalb des Siedepunkts von Silizium. Bevorzugt wird die Temperatur der Wände auf einem relativ niedrigen Niveau (bevorzugt zwischen 1.420 °C und 1.800 °C, insbesondere zwischen 1.500 °C und 1.600 °C) gehalten. Der Reaktor kann dazu geeignete Isolier-, Heiz- und/oder Kühlmittel aufweisen.
   Flüssiger Halbleiterwerkstoff sollte sich am Reaktorboden sammeln können. Der Boden des Reaktorinnenraumes kann dazu konisch ausgebildet sein mit einem Ablauf am tiefsten Punkt, um das Abführen des flüssigen Halbleiterwerkstoffs zu erleichtern. Das Abführen des flüssigen Halbleiterwerkstoffs sollte idealerweise im Chargenbetrieb oder kontinuierlich erfolgen. Der Reaktor weist entsprechend bevorzugt einen dafür geeigneten Ablauf auf. Weiterhin muss natürlich auch das in den Reaktor eingeleitete Gas wieder abgeführt werden. Neben einer Zuleitung für den Gasstrom ist dafür in der Regel eine entsprechende Ableitung vorgesehen sein.
   Der Gasstrom wird bevorzugt bei relativ hohen Geschwindigkeiten in den Reaktor eingeleitet, um eine gute Verwirbelung innerhalb des Reaktors zu gewährleisten. Im Reaktor herrscht bevorzugt ein Druck leicht oberhalb Normaldruck, insbesondere zwischen 1.013 und 2.000 mbar.
   Mindestens ein Abschnitt des Reaktorinnenraums ist in bevorzugten Ausführungsformen im Wesentlichen zylindrisch ausgebildet. Die Einleitung des Gasstroms kann über einen in den Innenraum mündenden Kanal erfolgen. Die Mündung dieses Kanals ist besonders im oberen Bereich des Innenraumes angeordnet, bevorzugt am oberen Ende des im Wesentlichen zylindrischen Abschnitts.
   Betreffend bevorzugte Eigenschaften des Gasstromes und des Reaktors wird insbesondere auf die WO 2010/060630 A2 verwiesen.
(3) In einem abschließenden Schritt das Überführen des flüssigen Halbleiterwerkstoffs in den festen Zustand unter Ausbildung von monokristallinen Kristallstrukturen.
   Im Folgenden werden die erfindungsgemäß angewandten Verfahrensvarianten erläutert, die zur Ausbildung der erwähnten monokristallinen Kristallstrukturen führen. Gemein haben alle diese Verfahrensvarianten, dass bei ihnen in herkömmlicher Ausführung von festem Halbleitermaterial als Ausgangsmaterial ausgegangen wird, das entsprechend in einem ersten Schritt aufgeschmolzen werden muss. Dieser Schritt kann im Rahmen des vorliegend beschriebenen Verfahrens entfallen, schließlich fällt das Halbleitermaterial ja unmittelbar oder gegebenenfalls nach entsprechender Kondensation in flüssiger Form an. Das erfindungsgemäße Verfahren bietet somit insbesondere in energetischer Hinsicht gegenüber herkömmlichen Verfahren große Vorteile.

### Variante 1

In einer von zwei alternativen Ausführungsformen des erfindungsgemäßen Verfahrens wird mit dem flüssigen Halbleiterwerkstoff eine Schmelze gespeist, aus der ein Einkristall aus dem Halbleiterwerkstoff, insbesondere ein Silizium-Einkristall, gezogen wird. Eine derartige Vorgehensweise ist auch als Czochralski-Verfahren bzw. als Tiegelziehverfahren oder als Ziehen aus der Schmelze bekannt. In der Regel wird dabei die zu kristallisierende Substanz in einem Tiegel knapp oberhalb ihres Schmelzpunktes gehalten. In diese Schmelze wird ein kleiner Einkristall der zu züchtenden Substanz als Keim eingetaucht und anschließend unter Drehen langsam nach oben gezogen, ohne dass dabei der Kontakt zu der Schmelze abreißt. Das erstarrende Material übernimmt dabei die Struktur des Keims und wächst zu einem großen Einkristall heran.

Im Rahmen eines vorliegenden Verfahrens wird ein solcher Tiegel nun mit dem in Schritt (2) aus dem Gasstrom auskondensierten und/oder abgetrennten flüssigen Halbleiterwerkstoff gespeist. Es können im Grunde monokristalline Halbleiterstangen in beliebiger Länge gezogen werden.

Gemäß der zweiten der zwei alternativen Ausführungsformen des erfindungsgemäßen Verfahrens wird mit dem flüssigen Halbleiterwerkstoff eine in einer Heizzone angeordnete Schmelze gespeist. Diese wird durch Absenkung und/oder durch Anheben der Heizzone derart abgekühlt, dass sich an ihrem unteren Ende eine Erstarrungsfront ausbildet, entlang derer der Halbleiterwerkstoff kristallisiert.

Bei bekannten vertikalen tiegelfreien Fließzonenverfahren (Float Zone-Verfahren) wird üblicherweise ein Stab aus Halbleitermaterial mit polykristalliner Kristallstruktur in einer Schutzgasatmosphäre bereitgestellt und, in der Regel an seinem unteren Ende, durch eine Induktionsheizung aufgeschmolzen. Es wird dabei stets nur eine relativ schmale Zone in die Schmelze überführt. Damit dies möglichst gleichmäßig geschieht, rotiert der Stab langsam. Die aufgeschmolzene Zone wird wiederum mit einem Impfkristall, welcher üblicherweise entgegengesetzt rotiert, in Kontakt gebracht. Dabei etabliert sich eine sogenannte "frei schwebende Zone", eine Schmelze, welche hauptsächlich durch Oberflächenspannung stabil gehalten wird. Diese Schmelzzone bewegt man nun langsam durch den Stab, was durch das erwähnte Absenken des Stabes mitsamt der Schmelze oder alternativ durch Anheben der Heizzone geschehen kann. Die aus der Heizzone austretende und in der Folge erkaltende Schmelze erstarrt unter Beibehaltung der vom Impfling vorgegebenen Kristallstruktur, es bildet sich also ein Einkristall. Fremdatome segregieren dagegen weitestgehend in die Schmelzzone und finden sich so nach Abschluss des Verfahrens in der Endzone des Einkristalls wieder. Diese kann abgetrennt werden. Eine Beschreibung für ein solches Verfahren bzw. einer dafür geeigneten Vorrichtung findet sich z.B. in der DE 60 2004 001 510 T2.

Durch Speisen der "frei schwebenden Zone" mit flüssigem Silizium aus Schritt (2) gemäß dem erfindungsgemäßen Verfahren lässt sich diese Vorgehensweise deutlich vereinfachen. Das Aufschmelzen von festem Silizium kann vollständig entfallen, da ja flüssiges Silizium aus dem Plasmareaktor bereitgestellt wird. Ansonsten kann die aus dem Stand der Technik bekannte Vorgehensweise jedoch unverändert belassen werden.

Mit Float Zone-Verfahren ist die Herstellung von qualitativ äußerst hochwertigen Siliziumeinkristallen möglich, da die Schmelze selbst berührungsfrei gelagert ist und somit mit Quellen für potentielle Verunreinigungen, z.B. Tiegelwände, überhaupt nicht in Berührung kommt. Insoweit ist ein Float Zone-Verfahren z.B. einem Czochralski-Verfahren deutlich überlegen.

Bei allen obigen Varianten ist es erforderlich, den flüssigen Halbleiterwerkstoff aus Schritt (2) aus dem Plasmareaktor in eine entsprechende Vorrichtung zu überführen, in der dann der Übergang des flüssigen Halbleiterwerkstoffs in den festen Zustand unter Ausbildung von monokristallinen Kristallstrukturen erfolgt. Bei einer solchen Vorrichtung handelt es sich im Fall von Variante 1 z.B. um den Tiegel, aus dem der Einkristall aus dem Halbleiterwerkstoff gezogen wird, im Fall von Variante 2 um eine Vorrichtung mit der in der Heizzone angeordneten Schmelze.

Überführt werden kann der flüssige Halbleiterwerkstoff z.B. mittels Rinnen und/oder Rohren, die beispielsweise aus Quarz, aus Graphit oder aus Siliziumnitrid gefertigt sein können. Gegebenenfalls können diesen Überführungsmitteln Heizeinrichtungen zugeordnet sein, um einem Erstarren des flüssigen Halbleiterwerkstoffs beim Transport vorzubeugen. Die Kopplung der Überführungsmittel an den Reaktorbehälter, in dem der flüssige Halbleiterwerkstoff aus dem Gasstrom auskondensiert und/oder abgetrennt wird, kann beispielsweise über eine siphonartige Rohrverbindung erfolgen. In dem Reaktorbehälter kann flüssiger Halbleiterwerkstoff nach Bedarf erzeugt werden, indem die Menge an Partikeln aus dem Halbleiterwerkstoff und/oder an der Vorläuferverbindung des Halbleiterwerkstoffs, die in den hocherhitzten Gasstrom eingespeist wird, entsprechend variiert wird. Der entstehende flüssige Halbleiterwerkstoff sammelt sich im Reaktorbehälter und erzeugt einen entsprechenden hydrostischen Druck. Über die siphonartige Rohrverbindung kann, bedingt durch diesen Druck, flüssiger Halbleiterwerkstoff kontrolliert aus dem Reaktorbehälter ab- bzw. der Vorrichtung, in der dann der Übergang des flüssigen Halbleiterwerkstoffs in den festen Zustand unter Ausbildung von monokristallinen Kristallstrukturen erfolgt, zugeführt werden.

## Patentansprüche

1. Verfahren zur Herstellung eines kristallinen Halbleiterwerkstoffs, insbesondere von kristallinem Silizium, umfassend die Schritte
• Einspeisen von Partikeln aus dem Halbleiterwerkstoff und/ oder einer Vorläuferverbindung des Halbleiterwerkstoffs in einen Gasstrom, wobei der Gasstrom eine ausreichend hohe Temperatur aufweist, um die Partikel aus dem Halbleiterwerkstoff aus den festen in den flüssigen und/oder gasförmigen Zustand zu überführen und/oder um die Vorläuferverbindung thermisch zu zersetzen,
• Auskondensieren und/oder Abtrennen des flüssigen Halbleiterwerkstoffs aus dem Gasstrom,
• Überführen des flüssigen Halbleiterwerkstoffs in einen festen Zustand unter Ausbildung von monokristallinen Kristallstrukturen,
wobei zur Ausbildung der monokristallinen Kristallstrukturen mit dem flüssigen Halbleiterwerkstoff eine Schmelze gespeist wird, aus der ein Einkristall aus dem Halbleiterwerkstoff gezogen wird, oder mit dem flüssigen Halbleiterwerkstoff eine in einer Heizzone angeordnete Schmelze gespeist wird, die durch eigene Absenkung und/ oder durch Anheben der Heizzone derart abgekühlt wird, dass sich an ihrem unteren Ende eine Erstarrungsfront ausbildet, entlang derer der Halbleiterwerkstoff in einer monokristallinen Struktur kristallisiert.

## Claims

1. Method for producing a crystalline semiconductor material, in particular crystalline silicon, comprising the steps of
• feeding particles of the semiconductor material and/or a precursor compound of the semiconductor material into a gas flow, wherein the gas flow has a sufficiently high temperature to convert the particles of the semiconductor material from the solid to the liquid and/or gaseous state and/or to thermally decompose the precursor compound,
• condensing out and/or separating the liquid semiconductor material from the gas flow,
• converting the liquid semiconductor material to a solid state with formation of monocrystalline crystal structures,
wherein, in order to form the monocrystalline crystal structures, a melt is fed with the liquid semiconductor material, a single crystal of the semiconductor material being pulled from said melt,
or a melt arranged in a heating zone is fed with the liquid semiconductor material, said melt being cooled by inherent lowering and/or by raising of the heating zone in such a way that, at its lower end, a solidification front forms along which the semiconductor material crystallizes in a monocrystalline structure.

## Revendications

1. Procédé de fabrication d'un matériau semi-conducteur cristallin, en particulier du silicium cristallin, comprenant les étapes consistant à
- alimenter un flux gazeux avec des particules constituées du matériau semi-conducteur et/ou d'un composé précurseur du matériau semi-conducteur,
dans lequel le flux gazeux présente une température suffisamment élevée pour faire passer les particules constituées du matériau semi-conducteur de l'état solide à l'état liquide et/ou gazeux et/ou pour décomposer thermiquement le composé précurseur,
- éliminer le matériau semi-conducteur liquide du flux gazeux par condensation et/ou le séparer de celui-ci,
- faire passer le matériau semi-conducteur liquide à l'état solide par réalisation de structures cristallines monocristallines,
dans lequel une masse fondue est alimentée avec le matériau semi-conducteur liquide pour réaliser les structures cristallines monocristallines, cela permettant d'extraire un monocristal du matériau semi-conducteur ou d'alimenter une masse fondue disposée dans une zone de chauffage avec le matériau semi-conducteur liquide, laquelle masse fondue est refroidie par un abaissement et/ou un soulèvement propre de la zone de chauffage de manière à ce qu'un front de solidification se forme à son extrémité inférieure, le long duquel le matériau semi-conducteur cristallise en une structure monocristalline.
